# EUROPÄISCHE PATENTSCHRIFT

(11) **EP 2 443 680 B1**
(45) Veröffentlichungstag und Bekanntmachung des Hinweises auf die Patenterteilung: **10.08.2016**
(21) Anmeldenummer: 10719327.8
(22) Anmeldetag: 05.05.2010
(51) Int. Cl.: H01L 51/00, H01L 51/50, H01L 51/54

(54) **VFAHREN ZUR HERSTELLUNG EINER LOCHTRANSPORTSCHICHT MIT P-DOTIERUNG**
METHOD OF MANUFACTURING A HOLE TRANSPORT LAYER WITH P-DOPING
PROCÉDÉ DE FABRICATION D'UNE COUCHE DE TRANSPORT DE TROUS À DOPAGE P

(30) Priorität: 20.05.2009 DE 102009022117
(43) Veröffentlichungstag der Anmeldung: 25.04.2012
(73) Patentinhaber: Siemens Aktiengesellschaft, 80333 München (DE)
(72) Erfinder: HERDER, Sabine, 91462 Dachsbach (DE); SCHMID, Günter, 91334 Hemhofen (DE); SUHONEN, Riikka, FI-90630 Oulu (FI); HARTMANN, David, 91056 Erlangen (DE); MALTENBERGER, Anna, 91359 Leutenbach (DE); SARFERT, Wiebke, 91074 Herzogenaurach (DE)
(86) Internationale Anmeldenummer: PCT/EP2010/056094
(87) Internationale Veröffentlichungsnummer: WO 2010/133449

(56) Entgegenhaltungen:
- WO-A1-2008/106917
- US-A1- 2005 230 665
- US-A1- 2006 232 200
- US-A1- 2007 141 396
- ZHANG X ET AL: "Solution-processed p-doped hole-transport layer and its application in organic light-emitting diodes" APPLIED SURFACE SCIENCE, ELSEVIER, AMSTERDAM, NL, Bd. 256, Nr. 14, 1. Mai 2010 (2010-05-01), Seiten 4468-4472, XP026997814 ISSN: 0169-4332 [gefunden am 2010-02-01]

## Beschreibung

Die Erfindung betrifft ein Verfahren zur Herstellung einer Lochtransportschicht mit einem p-Dotierungsmittel.

Bekannt ist, dass die Effizienz, beispielsweise ausgedrückt in cd/A oder lm/W und die Lebenszeit (in Stunden) von organischen Leuchtdioden durch Einführung von speziellen Schichten zum Elektronen- oder Lochtransport gesteigert werden kann. Da die Schichten aus Lösung prozessiert werden, ist insbesondere die Löslichkeit der Materialien eine Grundvoraussetzung für deren Einsetzbarkeit.

Lochtransportschichten für polymerbasierte organische Leuchtdioden werden meist aus wässriger Lösung von Poly(3,4-ethylendioxythiophen) mit eindotierter Polystyrolsulfonsäure (PEDOT:PSS) hergestellt.

Es hat sich jedoch herausgestellt, dass dieses Material Nachteile hat. Zum einen löst die enthaltene stark saure Sulfonsäure die darunter liegende Elektrodenschicht, die in der Regel aus ITO (Indium Zinn Oxid) besteht, an und zum zweiten weiß man, dass die Grenzfläche zwischen der Licht emittierenden Schicht und der Lochtransportschicht aus PEDOT:PSS eine für wirtschaftliche Anwendungen zu kurze Lebensdauer hat.

Aus der US 2007/141396 A1 ist eine OLED mit einem so genannten "charge generation layer" einer Schicht mit Lochtransporteigenschaften, bekannt. Aus der US 2006/232200 A1 ist eine OLED bekannt, bei der eine Schicht aus einer Mischung von PEDOT und MoO₃ offenbart wird. Aus der US 2005/230665 schließlich ist ein Matrixmaterial mit einem organometallischen Dotanden bekannt. Aus keiner Druckschrift ist jedoch ein Verfahren zur Herstellung einer Lochtransportschicht bekannt, das die Ausbildung eines Charge-Transfer-Komplexes innerhalb der Lochtransportschicht begünstigt.

Aufgabe der vorliegenden Erfindung ist es daher, ein Verfahren zur Herstellung einer Lochtransportschicht zu schaffen, das die Nachteile des Standes der Technik überwindet.

Diese Aufgabe wird durch den Gegenstand der vorliegenden Beschreibung mit Figuren und den Ansprüchen gelöst.
1. Dementsprechend ist Gegenstand der Erfindung ein Verfahren zur Herstellung einer Lochtransportschicht mit folgenden Arbeitsschritten:
   - Lösen von Rheniumheptoxid in einem Donorenthaltenen Lösungsmittel
   - Zugabe einer Lösung eines Matrixmaterials,
   - nasschemische Aufbringung der Formulierung auf eine untere Schicht
   - Sukzessives Entfernen des Donorlösungsmittel durch Thermolyse und Verschieben des Gleichgewichts zwischen Rheniumheptoxid und Donorlösungsmittelmolekül auf die Seite des Charge-Transfer-Komplexes mit dem Ladungstransportmaterial nach der Gleichung:

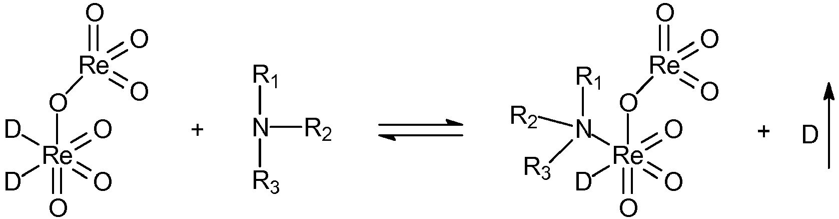

"Aus Lösung prozessierbar" heißt in diesem Zusammenhang grundsätzlich, dass der Arbeitsschritt zur Aufbringung der Lochtransportschicht nicht über Abscheidung im Vakuum, wie beispielsweise im Molekularpumpenvakuum, sondern über nasschemische Arbeitsschritte mit wesentlich geringerem Aufwand erfolgt. Insbesondere ist vorgesehen, dass die Lochtransportschicht durch einfache und unter Normalbedingungen stattfindende, nasschemische Methoden, also über Spin Coating, Sprühen, Aufschleudern oder Drucken, beispielsweise über Doctor-Blading (Rakeln), Gravur-printing (Tiefdruck), Tintenstrahl, Flexodruck oder Offset-Drucken, herstellbar ist.

Als Matrix werden insbesondere Materialien eingesetzt, die zum Lochtransport fähig also zur Stabilisierung positiver Ladungen einsetzbar sind. Beispiele für polymere Lochtransporter (hohes Molekulargewicht) sind neben vielen anderen: Polyvinylcarbazol (PVK), Poly(N,N'-bis,(4-butylphenyl)-N,N'-bis(phenyl)benzidine (PTPD), Polyaniline (PANI) und.

Aus diesen Materialien können beliebige Co-polymere und/oder Block-co-polymere, die auch "isolierende", aber beispielsweise lösungsvermittelnde Einheiten enthalten können, eingesetzt werden. Beispiele dafür sind Polysytrol, ABS, Ethyleneinheiten, Vinyleinheiten etc.

Lochtransporter mit niedrigem Molekulargewicht sog. Small Molecules können ebenfalls verwendet werden.

Im Folgenden werden verschiedene Beispiele für Lochtransporter mit niedrigem Molekulargewicht aufgezählt:
N,N'-Bis(naphthalen-1-yl)-N,N'-bis(phenyl)-9,9-dimethyl-fluoren
N,N'-Bis(3-methylphenyl)-N,N'-bis(phenyl)-9,9-diphenyl-fluoren
N,N'-Bis(naphthalen-1-yl)-N,N'-bis(phenyl)-9,9-diphenyl-fluoren
N,N'-Bis(naphthalen-1-yl)-N,N'-bis(phenyl)-2,2-dimethylbenzidin
N, N'-Bis(3-methylphenyl)-N,N'-bis(phenyl)-9,9-spirobifluoren 2,2',7,7'-Tetrakis(N, N-diphenylamino)-9,9'-spirobifluoren
N, N'-Bis(naphthalen-1-yl)-N,N'-bis(phenyl)-benzidin
N, N'-Bis(naphthalen-2-yl)-N,N'-bis(phenyl)-benzidin
N, N'-Bis(3-methylphenyl)-N,N'-bis(phenyl)-benzidin
N,N'-Bis(3-methylphenyl)-N,N'-bis(phenyl)-9,9-dimethyl-fluoren
N,N'-Bis(naphthalen-1-yl)-N,N'-bis(phenyl)-9,9-spirobifluoren
Di-[4-(N,N-ditolyl-amino)-phenyl]cyclohexan
2,2',7,7'-tetra(N, N-di-tolyl)amino-spiro-bifluoren
9,9-Bis[4-(N,N-bis-biphenyl-4-yl-amino)phenyl]-9H-fluoren
2,2',7,7'-Tetrakis[N-naphthalenyl(phenyl)-amino]-9,9-spirobifluoren
2,7-Bis[N,N-bis(9,9-spiro-bifluorene-2-yl)-amino]-9,9-spirobifluoren
2,2'-Bis[N,N-bis(biphenyl-4-yl)amino]-9,9-spirobifluoren
N, N'-bis(phenanthren-9-yl)-N,N'-bis(phenyl)-benzidin
N, N,N',N'-tetra-naphthalen-2-yl-benzidin
2,2'-Bis(N,N-di-phenyl-amino)-9,9-spirobifluoren
9,9-Bis[4-(N,N-bis-naphthalen-2-yl-amino)phenyl]-9H-fluoren
9,9-Bis[4-(N, N'-bis-naphthalen-2-yl-N,N'-bis-phenyl-amino)-phenyl]-9H-fluoren
Titanium oxide phthalocyanin
Copper phthalocyanin
2,3,5,6-Tetrafluoro-7,7,8,8,-tetracyano-quinodimethan
4,4',4" -Tris(N-3-methylphenyl-N-phenyl-amino)triphenylamin
4,4',4" -Tris(N-(2-naphthyl)-N-phenyl-amino)triphenylamin
4,4',4" -Tris(N-(1-naphthyl)-N-phenyl-amino)triphenylamin
4,4',4" -Tris(N,N-diphenyl-amino)triphenylamin Pyrazino[2,3-f][1,10]phenanthroline-2,3-dicarbonitril
N, N,N' ,N' -Tetrakis(4-methoxyphenyl)benzidin
2,7-Bis[N,N-bis(4-methoxy-phenyl)amino]-9,9-spirobifluoren
2,2'-Bis[N,N-bis(4-methoxy-phenyl)amino]-9,9-spirobifluoren
N, N'-di(naphthalen-2-yl)-N,N'-diphenylbenzene-1,4-diamin
N,N'-di-phenyl-N,N'-di-[4-(N,N-di-tolyl-amino)phenyl]benzidin
N,N'-di-phenyl-N,N'-di-[4-(N,N-di-phenyl-amino) phenyl] benzi din.

Die Lochtransporter können allein oder in Kombination eingesetzt werden. Dabei hat sich herausgestellt, dass eine Mischung aus Verbindungen mit hohem und niedrigem Molekulargewicht Vorteile bei der Filmbildung zeigt. Materialanteile höheren Molekulargewichts in der Formulierung verbessern deren *Planarisierungsfähigkeit .* Eine bevorzugte Kombination ist die Mischung aus PTPD und NPB. Die Mischungsanteile können in weiten Bereichen zwischen 0 und 100%, bezogen auf den Gesamtanteil an Lochtransporter, variiert werden.

Eine Lochtransportschicht ist in allen organischen elektronischen Bauelementen wie Transistoren, Dioden, Kondensatoren, Solarzellen, Photodioden, elektrochromen und selbstemittierenden Bauelementen verwendbar. Beispielsweise wurde sie mit großem Erfolg bereits in selbstemittierenden Bauteilen eingesetzt.

Ein selbstemittierendes organisches elektronisches Bauteil ist vornehmlich eine Leuchtdiode. Eine derartige organische Leuchtdiode hat grundsätzlich den folgenden Aufbau: Auf einem transparenten Substrat befindet sich eine untere Elektrodenschicht, die transparent ist. Darüber befinden sich die eigentlich aktive emittierende Schicht und darüber die zweite Elektrode. Zur besseren Performance werden zwischen den beiden Elektroden und der organischen aktiven Schicht Zwischenschichten eingebracht.

Die Lochtransportschicht ist eine dieser Zwischenschichten, durch die Löcher oder positive Ladungen von der Elektrode zu der emittierenden Schicht transportiert werden. Das Material zur Bildung der Lochtransportschicht umfasst ein Lösungsmittel, eine Matrix, die in dem Lösungsmittel gelöst vorliegt und ein p-Dotierungsmittel, das die Eignung des Materials als Lochleiter zu wirken, verstärkt.

Als p-Dotierungsmittel eignen sich vor allem Metallverbindungen, die von relativ großen Metallionen, insbesondere solche der höheren Übergangsmetallgruppen, abstammen. Insbesondere die Metalloxide sind aufgrund ihres starken Lewis-Säure-Charakters dazu geeignet, die Zahl freier Löcher in der Lochleitermatrix zu erhöhen.

Aus der Literatur sind derartige Beispiele bekannt, wie Molybdenoxid (MoO₂; MoO₃), Wolframoxid (WO₃), Vanadiumoxid (V₂O₅) und Rhenium(VI)oxid (ReO₃) und Rhenium(VII)oxid, deren Eignung als p-Dotanden nachweisbar ist. Dabei werden diese Metallverbindungen als Dotierungsmittel in Vakuumanlagen bei ca. 10⁻⁴Pa (also durch Turbo-Molekularpumpen erzeugte Bedingungen) über Vakuum-Abscheidung aufgebracht. Dies ist ein enormer Aufwand, der bei lösungsprozessierbaren Metallverbindungen entfällt und damit zu einer drastisch erhöhten Wirtschaftlichkeit der gesamten Bauteile führt.

Überraschend hat sich nun gezeigt, dass es Möglichkeiten gibt, Rheniumheptoxid (Re₂O₇) gemeinsam mit dem Lochtransporter-Matrix-Material in Lösung zu bringen und somit ein wirkungsvolles p-Dotierungsmittel, das aus Lösung prozessierbar ist, zu schaffen. Dabei kann einerseits die Metallverbindung, also beispielsweise die Rheniumverbindung, durch Komplexierung/Koordination an Lösungsmittelmoleküle in Lösung gebracht werden und andererseits durch Komplexierung/Koordination an das Lochtransportermatrixmaterial. Diese beiden Lösungsmechanismen können auch in Kombination vorliegen.

Rheniumheptoxid (Re₂O₇) ist eine relativ starke Lewis-Säure mit einer relativ niedrigen Oxidationskraft, das heißt die Tendenz, andere Moleküle zu oxidieren ist gering. Dies ist besonders vorteilhaft, da eine irreversible Oxidierung des Matrixmaterials verhindert werden soll. Das gelöst eingesetzte Rheniumheptoxid zerfällt unter Umständen während der Verarbeitung des organischen elektronischen Bauteils, des "Device", insbesondere während einer Thermolyse, möglicherweise teilweise oder ganz zu Rheniumtrioxid (Re(VI)O₃) und/oder Rheniumpentoxid (Re(V)₂O₅).

Möglicherweise kann deshalb im fertigen Produkt, in der Lochtransporterschicht nur ReO₃ und/oder Re₂O₃ nachgewiesen werden, obwohl die Schicht nasschemisch, also aus Lösung prozessierbar und mit Rheniumheptoxid hergestellt wurde. Die Eignung als Dotierungsmittel ist von diesem Zerfall wie unten gezeigt wird, unbeeinträchtigt. Besonders bevorzugt ist der Fall, wo sich die Oxidationsstufe des Rheniums während der Prozessierung nicht ändert. Welche Reaktionen bei der Thermolyse stattfinden, hängt sehr stark von dem unterstützenden Lösungsmittel und/oder dem Lösungsmittel der Formulierung ab.

VermutlicIm Folgenden ist die Struktur des Re₂O₇ in gelöster Form, wobei "D" hier für die Donorgruppen des Lösungsmittels und/oder des Lochtransportmatrixmaterials steht, gezeigt.

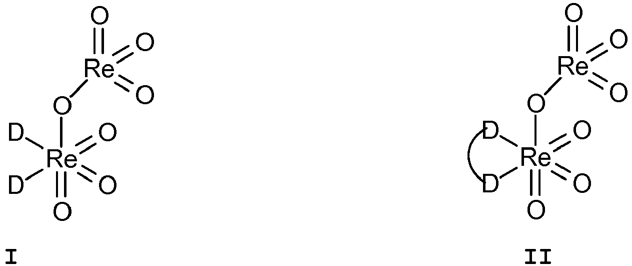

Die Struktur I zeigt den einfachen Fall mit einer Anbindung des Lösungsmittels/Lochtransportmatrixmaterials auf eine freie Valenz am Metallatom, Struktur II zeigt den Fall, dass das Lösungsmittel/Lochtransportmatrixmaterial mehrzähnig an dem Metallatom koordiniert.
Ein ähnliches Bild ergibt sich, wenn anstelle der Oxide beispielsweise die Perrhenylcarboxylate eingesetzt werden: 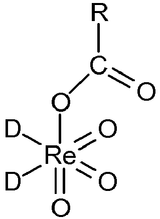 und

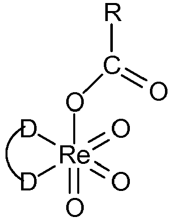

Dies sind die vermuteten Donor-komplexierten Strukturen der Perrhenylcarboxylates. Wie ersichtlich, komplexiert das Ladungstransportmaterial/Lösungsmittel am Rhenium und das Carbonyl wird bei der Übernahme einer positiven Ladung durch das Rheniumatom unter Dotierung des Lochtransportmatrixmaterials als Anion freigesetzt (siehe Schema 1 und 2 unten). Als Carboxylate können Alkylcarboxylate, wie beispielsweise Acetat und Propionat, Heteroarylcarboxylate wie Benzoat oder Picolinat, jeweils auch als ganz oder teilweise fluorierte Derivate davon, eingesetzt werden.

Diese Strukturmodelle am Rheniumatom erklären vermutlich auch, dass das Rheniumheptoxid in (Tetrahydrofuran) THF, Dioxan, Ethylenglycoldimethylether, Acetonitril und anderen Lösungsmittel mit Donoren leicht löslich ist.

Am Beispiel Rheniumheptoxid wird schematisch gezeigt, wie die Metallverbindung die positive Ladung stabilisiert, bzw. das Loch für den Ladungsträgertransport auf dem Matrixmaterial erzeugt.

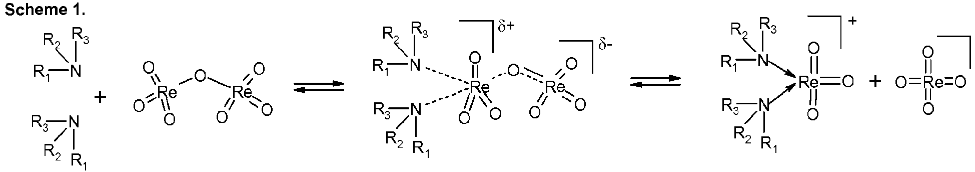

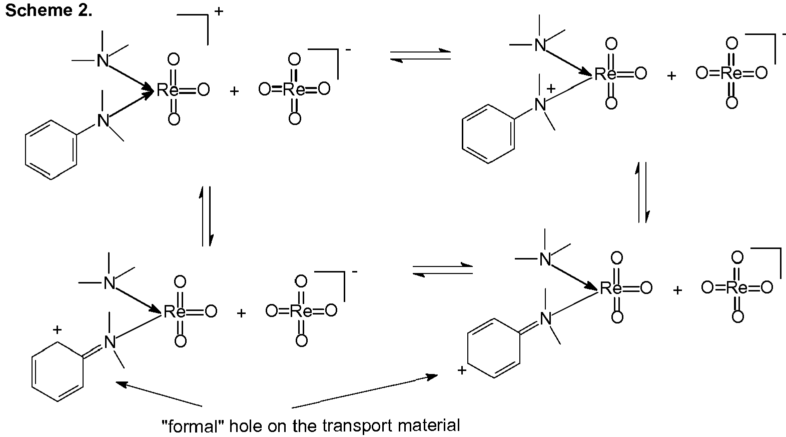

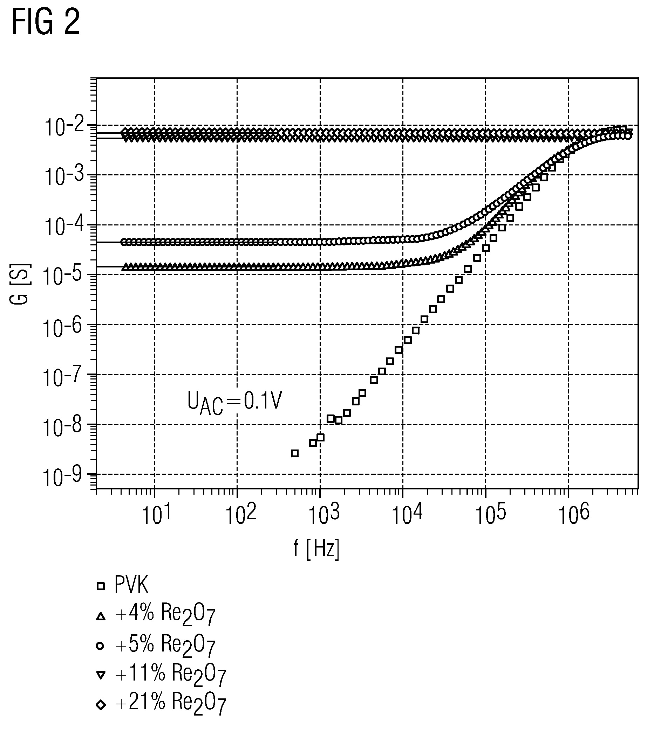

Fig. 2. The mechanism for p-doping with Re₂O₇ as a p-dopant

Als lösliche Matrixmaterialien werden zudem Polymere oder Small Molecules mit oder ohne aromatischem Kern/Kernen in der Basisstruktur. eingesetzt. Es gibt keine Beschränkung auf polymere Matrixmaterialien, weil dieses System der Loch-Stabilisierung in der Lochtransportschicht auch bei den "small molecules" einsetzbar ist.

Das Verhältnis der Anteile der Dotierungsmittel in dem Material kann variieren, es kann zwischen 0.01 und 1 liegen. 1 bedeutet, dass gleich viele Anteile Matrixmaterial wie Dotierungsmittel vorliegen. Bevorzugte Verhältnisse liegen im Bereich von 1 - 30% Anteil an Dotierungsmittel.

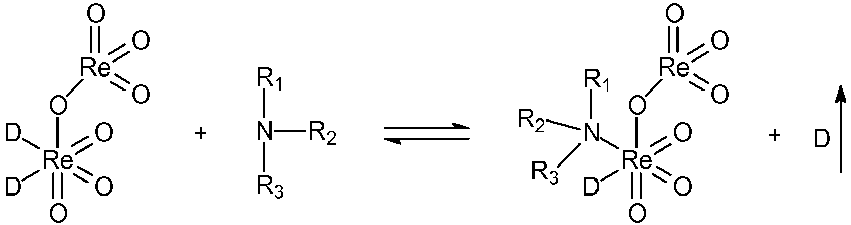

Diese, hier wieder rein exemplarisch am Beispiel Rhenium gezeigte, Reaktion findet in einem Gleichgewichtsprozess statt, so dass durch sukzessives Entfernen des Donors, der beispielsweise Teil des Lösungsmittels ist, das Gleichgewicht auf die Seite des Charge-Transferkomplexes mit dem Ladungstransportermaterial verschoben werden kann. Im oben gezeigten Schema wird diese Entfernung durch das "D" mit Pfeil nach oben angedeutet. Das Entfernen der Donoren D kann durch Abreaktion, Abdampfen und/oder Ausfällen oder sonstiges geschehen. Beispielsweise werden die Donoren, die ebenfalls bevorzugt leicht flüchtig sind durch Erhitzen und/oder Abdampfen des Lösungsmittels entfernt. Wiederum für das Beispiel Rheniumheptoxid können dabei Temperaturen von über 150°C, beispielsweise zwischen 150°C und 250°C erforderlich sein.

Prinzipiell können zwei Wege zur Herstellung des dotierten Materials für die Lochtransportschicht eingeschlagen werden. Zum einen wird eine Formulierung dadurch hergestellt, dass die Metallverbindung, beispielsweise das Rheniumheptoxid, in einem geeigneten Donorlösungsmittel gelöst wird. Dabei hat es sich bei Rheniumheptoxid als vorteilhaft erwiesen, dass das Donorlösungsmittel in einem molaren 2 bis 10-fachen Überschuss eingesetzt wird. Es kann auch ein Lösungsmittelgemisch eingesetzt werden. Zum zweiten kann das Rheniumheptoxid in einem unterstützenden Lösungsmittel gelöst in das Lösungsmittel oder Lösungsmittelgemisch für die Reaktion mit dem Matrixmaterial eingebracht werden. Zu der fertigen Lösung des Rheniumheptoxids wird dann eine Lösung des Matrixmaterials, das polymer oder in Form von small molecules vorliegen kann, zugegeben. Die Abreaktion oder die Dotierung des Matrixmaterials kann optisch erkennbar sein, beispielsweise kann sich durch die Bildung des Charge-transfer Komplexes die Farbe der Lösung verändern. Dabei werden am metallischen Zentralatom, beispielsweise also am Rheniumatom, die Donor-Moleküle des Lösungsmittels zumindest teilweise durch Moleküle des Lochtransportermaterials ersetzt.

Optisch ist zunächst ein starker Farbumschlag der Lösung von transparent farblos nach dunkelgrün erkennbar. Dieser Farbumschlag indiziert die Entstehung des Charge-Transfer-Komplexes zwischen dem PVK und dem Rheniumheptoxid und damit die erfolgreiche Dotierung.

Zum Zweiten kann die Herstellung der dotierten Lochtransportschicht dadurch erfolgen, dass zunächst ein thermisch labiler Metallkomplex hergestellt und in die Formulierung eingebracht wird, der sich dann während der Thermolyse zur Entfernung des Lösungsmittels der aus Lösung prozessierten Formulierung zersetzt und die dotierten Lochtransportschicht erzeugt.

Die Lochleiterschicht entsteht nach dem Aufbringen folgendermaßen: Falls nicht schon bei der Herstellung der Formulierung geschehen, zersetzt sich der Donor-Komplex des Rheniumheptoxids unter Abspaltung eines bzw. mehrer Donorliganden. Die frei werdenden Koordinationsstellen nehmen dabei Moleküle des Lochleiters (Matrixmaterial) ein.

In der bevorzugten Variante der Herstellung ändert sich die Oxidationsstufe des Rhenium nicht und man erhält eine Rheniumheptoxid-dotierte Lochleiterschicht.

Es existieren jedoch Donorkomplexe (Doktorarbeit von Fitz. E. Kühn ??), wo die thermolytische Zersetzung des Donorkomplexes unter Reduktion des Rheniumheptoxids verläuft. Hierbei entstehen (Re(VI)O₃) und/oder Rheniumpentoxid (Re(V)₂O₅) dotierte Lochleitersysteme.

Erkennbar wird die Komplexbildung durch eine farbliche Änderung unter Bildung eines Charge-Transfer-Komplexes.

Lochtransportschichten, die durch Koevaporation der Metallverbindungen mit dem Lochtransportmaterial hergestellt wurden, haben in Bauelementen zur Charakterisierung der Lochleitfähigkeit vergleichbare Lochleitfähigkeiten mit den aus Lösung hergestellten gezeigt. Deshalb bieten die erfindungsgemäß vorgeschlagenen löslichen Metallverbindungen auch eine kostengünstige alternative Herstellungsmethode zu den aus der Dampfphase prozessierten.

Beispielsweise werden als Donor-haltige Lösungsmittel die folgenden eingesetzt: Tetrahydrofuran (THF), Toluol, Ethylenglycoldiethylether, Chlorbenzol, Propylenglycolmethyletheracetat, weitere organische und anorganische sowie polare oder unpolare und Lösungsmittelgemische sind auch im Sinne der Erfindung einsetzbar. Organische Lösungsmittel werden dabei bevorzugt, damit das Lochtransportermaterial, das polymer, oligomer oder in Form von small molecules vorliegen kann, nicht ausgefällt wird.

Es gibt auch den Fall, dass ReOx mit dem Lochtransportermatrixmaterial also beispielsweise mit den small molecules NMP oder Poly-TPD ohne weiteres Lösungsmittel, zusammen auch ohne Donorlösungsmittel, formuliert wird. Es konnte gezeigt werden, dass dies ebenfalls funktioniert.

### Beispiele:

### Beispiel 1

Rheniumheptoxid (Re₂O₇), gelöst in trockenem THF (Tetrahydrofuran) wird mit Poly(9-vinylcarbazol) (PVK) gelöst in trockenem Toluol unter Argon-Atmosphäre eingesetzt, wobei das Verhältnis zwischen THF und Toluol ungefähr 2:3 beträgt. Die beiden Lösungen werden zunächst getrennt gerührt und dann zusammengegeben. Diese Mischung wird auf einer strukturierten, gewaschenen und einem RIE (Reactive Ion Etching) Prozess unterworfener Elektrodenschicht, beispielsweise aus ITO (Indium Tin Oxide) durch spin-coating, beispielsweise mit einer Geschwindigkeit von 500rpm, aufgebracht.

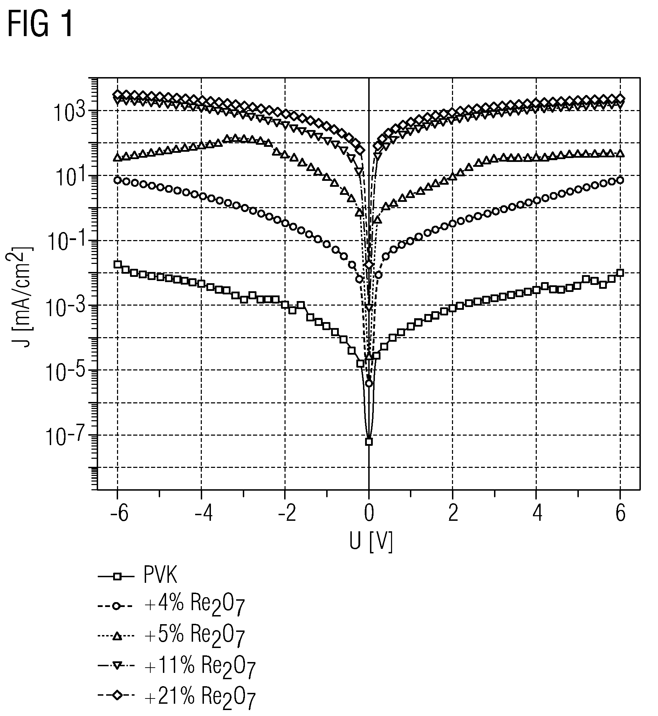

Dabei wird eine ca. 100nm dicke Schicht erzeugt, auf der eine weitere Elektrode, beispielsweise eine Aluminiumelektrode, die durch eine Maske thermisch aufgebracht wird, erzeugt wird. Im Ergebnis liegt eine PVK:Re₂O₇-dotierte Lochtransportschicht zwischen zwei Elektroden (ITO und Aluminium) vor. Dabei wird das Verhältnis zwischen PVK und Rheniumheptoxid in der Schicht im Bereich von 1:1 bis 100 : 1 variiert. An diesem Aufbau können sowohl die Lochleiteigenschaften als auch die Leitfähigkeiten der jeweiligen Schichten gemessen werden. Siehe die Ergebnisse in der Diskussion der Figuren 1 bis 5.
Figur 1 zeigt eindrucksvoll, wie sich die Strom-Spannungskurve mit zunehmendem Rheniumgehalt hin zu höheren Stromdichten hebt. In Figur 1 sind die Graphiken wiedergegeben, die die gemessenen Strom/Spannungskurven von ITO Elektroden, die gemäß Beispiel 1 mit einer 100nm Schicht PVK bedeckt sind. Vergleichsweise gibt es eine Messung ohne Dotierung (0% Re₂O₇) und in verschiedenen Dotierungskonzentrationen. So liegt die Stromdichte bei 4 Volt im reinen PVK bei ca. 10⁻² mA/cm², wohingegen sie bei gleicher Spannung im dotierten Material (21% Re₂O₇) bei 10³ mA/cm² liegt.
Figur 2 zeigt die Leitwert gegen Frequenz-Messungen der gleichen Aufbauten wie in Figur 1. Es zeigt sich, dass sich insbesondere bei niedrigen Frequenzen der Leitwert im Falle einer Dotierung um mehr als 6 Größenordnungen erhöht (Beispiel 100 Hz: reines PVK < 10⁻⁹ S, 11% ReOx in PVK > 10⁻³ S. Die dotierten Schichten zeigen rein ohmsches Verhalten, da die gemessenen Leitwerte unabhängig von der Frequenz werden.

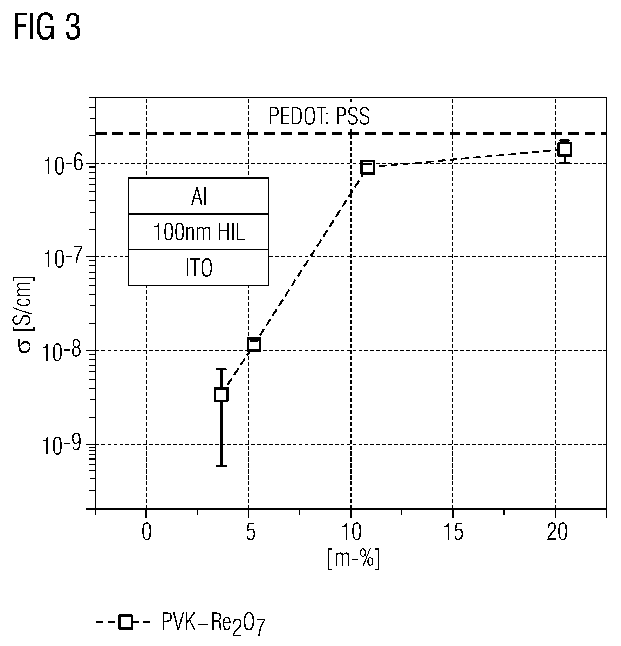

Figur 3 schließlich zeigt den abgeleiteten Verlauf der Leitfähigkeit des Aufbaus gemäß Beispiel 1 mit zunehmender Dotierstoffkonzentration. Als Referenzlinie ist die Leitfähigkeit des bisher bekannten und gebräuchlichen Lochleiters PEDOT:PSS angegeben. Zu erkennen ist, dass mit einer Dotierstoffkonzentration von um die 20% Leitfähigkeitswerte im Bereich des PEDOT:PSS erwartet werden.

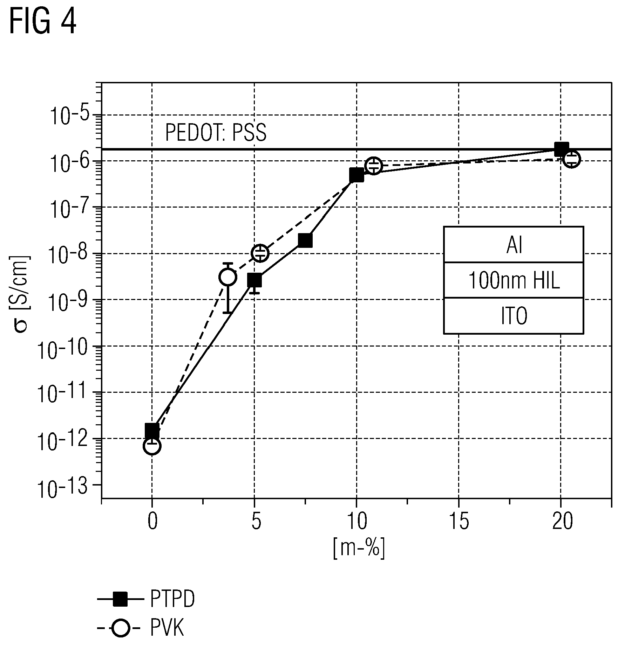

Figur 4 zeigt, dass die Wahl des Lochtransportmatrixmaterials einen wenn überhaupt nur geringen Einfluss auf die Leitfähigkeit des Aufbaus des Bauelements hat.

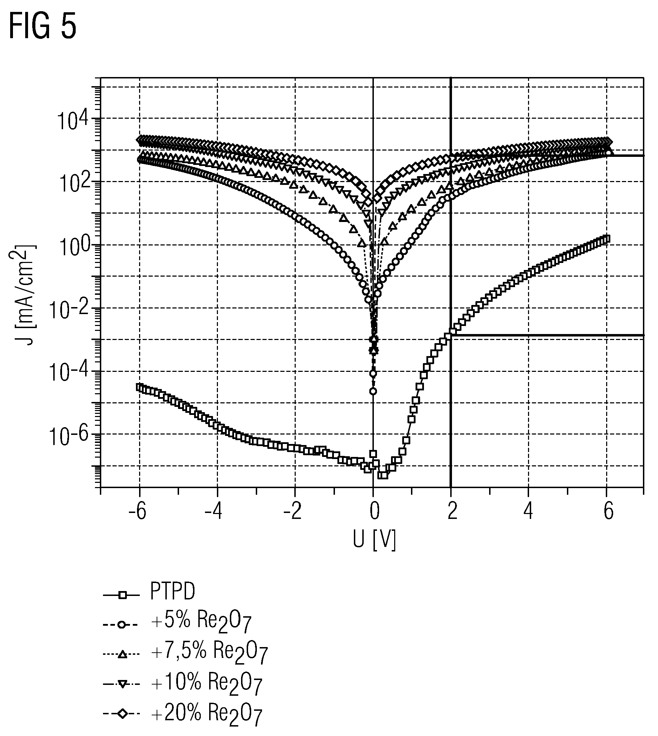

Figur 5 zeigt die gleiche Messung wie Figur 1, nur dass hier als Lochtransportermatrixmaterial nicht PVK, sondern PTPD eingesetzt ist. Die Strom-Spannungscharakteristiken von 100nm-Einzelschichten PTPD, dotiert mit 0 bis 20% Re₂O₇ zwischen einer ITO und einer Aluminiumelektrode, werden in Figur 5 gezeigt. Wie ersichtlich kann die Leitfähigkeit des Systems durch eine Zugabe von geringen Mengen Re₂O₇ um das 3 Größenordnungen gesteigert werden.

### Beispiel 2:

Die Lösung wurde analog Beispiel 1 hergestellt. Die Mischung wurde wieder auf einer strukturierten, gewaschenen und einem RIE Prozess unterworfener Elektrodenschicht aus ITO durch spin-coating aufgebracht. Diesmal wurde die Geschwindigkeit des Spin-Coatings so variiert, dass Schichtdicken zwischen 30 und 150nm resultierten. Eine herkömmliche polymerbasierte organische Leuchtdiode (OLED) wurde dann auf der Schicht aufgebaut. Dazu wurden nacheinander folgende Schichten aufgebracht: Zunächst eine polymere Licht emittierende Schicht, die lösungsprozessiert aus einem trockenem organischen Lösungsmittel aufgebracht wurde. Das Lösungsmittel wurde thermisch entfernt. Darauf wurde eine Elektroneninjektionsschicht mit einer niedrigen Austrittsarbeit, beispielsweise aus Barium, Calcium oder Magnesium aufgebracht, darauf eine metallische Schutzschicht mit einer hohen Austrittsarbeit, beispielsweise Aluminium oder Silber. Schließlich wurde das Bauteil nach üblichen Methoden verkapselt.

### Beispiel 3:

Durchführung analog zu Beispiel 2, wobei als Lochtransportmatrixmaterial Poly(N,N'-bis(4-butylphenyl)-N,N'-bis(phenyl)-benzidin (PTPD) eingesetzt wurde.

Dazu wurde aufgrund der Unlöslichkeit des PTPDs in Toluol ein Lösungsmittelsystem Chlorbenzol (CB) und THF umfassend, eingesetzt. CB lag in einem Verhältnis von 9:1 zu THF vor. Das Rheniumheptoxid wurde in trockenem THF vorab gelöst und dann mit dem PTPD in CB zusammengebracht.

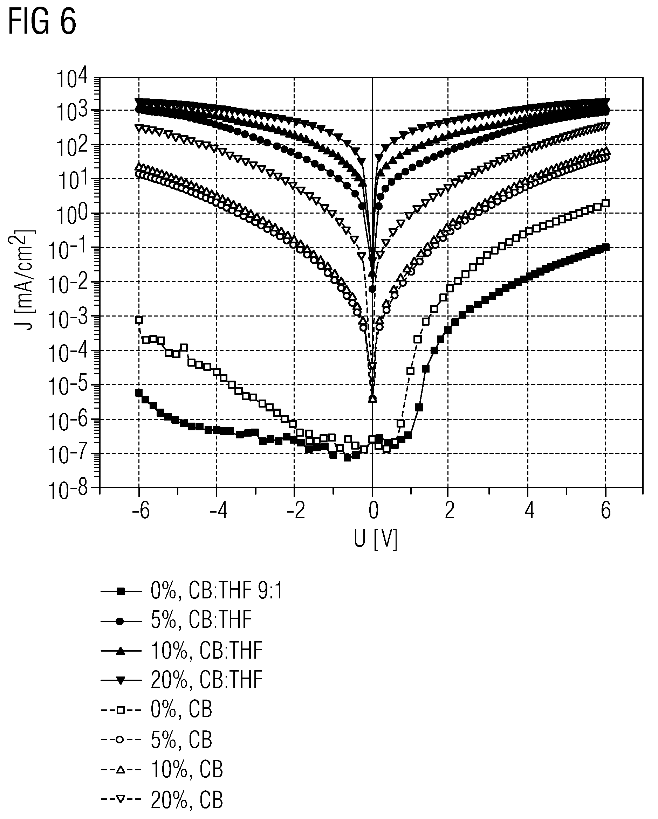

Figur 6 zeigt die Strom-Spannungskurve für den Aufbau gemäß Beispiel 1 einmal mit einer Formulierung aus den Komponenten Lochtransportmatrixmaterial und Dotierungsmittel in dem Lösungsmittel CB alleine (leere Symbole) und mit einer Lösungsmittelmischung aus CB und THF (gefüllte Symbole). Die beiden untersten Kurven zeigen das Matrixmaterial PTBD einmal gelöst die CB allein (leere Kästchen) und zum anderen gelöst im Lösungsmittelgemisch CB mit THF (gefüllte Kästchen). Das Ergebnis ist identisch zu dem in Figur 1 beschriebenem, weil auch hier sich wieder gezeigt hat, dass der höchste Dotierungsgrad mit etwa 20 % Re₂O₇ in stabiler Matrix (gefüllte nach unten zeigende Dreiecke) die beste (oberste) Strom/Spannungskurve hat.

Dabei darf nicht unerwähnt bleiben, dass die Lösung aus PTPD und Re₂O₇ in Chlorbenzol allein nicht stabil ist_In diesem Fall fällt aus der Lösung ein Niederschlag aus und die Dotierung ist nur bedingt oder unterbleibt sogar ganz. Außerdem, wenn die Dotierungsreaktion nicht oder nur bedingt stattfindet, sind die I/V (Strom-Spannungskurve) -Charakteristiken nicht symmetrisch, weil der Lochtransport von der Aluminium-Kathode verhindert wird. Hinzu kommt, dass der Strom niedriger im Vergleich zu den dotierten Systemen ist, weil nur eine begrenzte Anzahl an Ladungsträgern vorhanden ist.

### Beispiel 4:

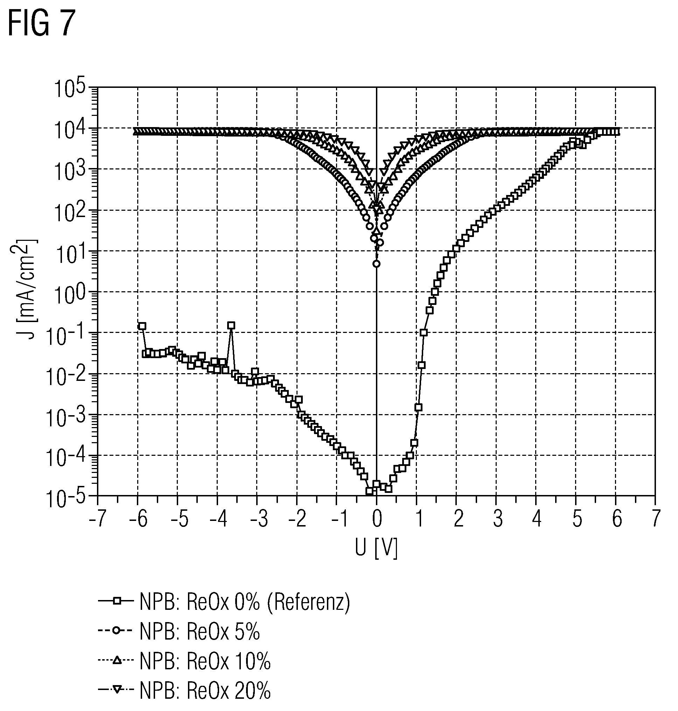

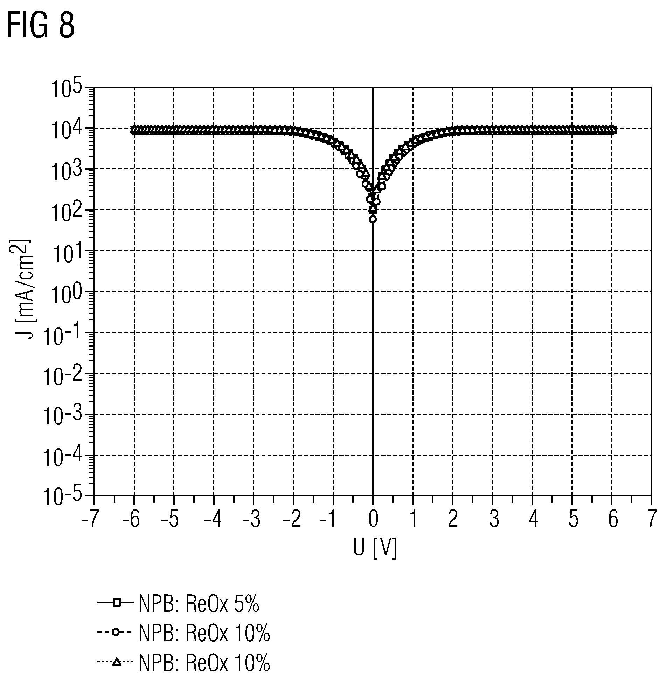

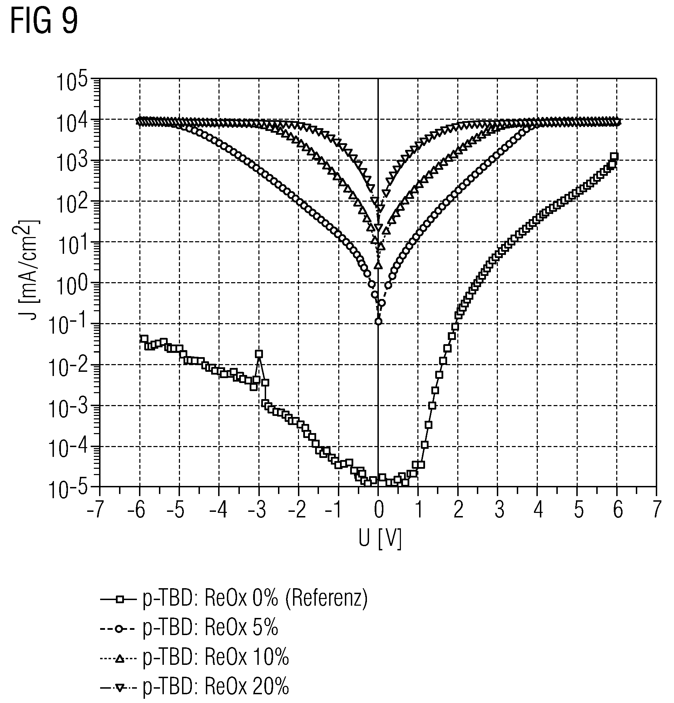

Vergleich von über die Dampfphase aufgebrachtem NPB als typischen Vertreter der small molecules nach dem Stand der Technik (Figur 7) und aus Lösung prozessiertem NPB (Figur 8), beide mit der Menge im Bereich von 0 bis 20% Re₂O₇ dotiert.

Figur 7 zeigt die Strom-Spannungskurve des Aufbaus gemäß Beispiel 1, also der Einzelschicht zwischen zwei Elektroden aus ITO und Aluminium. Um den Einfluss der Herstellungsmethode auf die Performance zu untersuchen, wurde hier anstelle der lösungsprozessierten Polymerschicht eine 60nm Einzelschicht aus thermisch aufgedampften NPB mit einer Re₂O₇-Dotierung im Bereich von 0 bis 20% zwischen den Elektroden vermessen.

Figur 8 zeigt den gleichen Aufbau und die gleiche Messung mit der aus Lösung prozessierten, in diesem Fall über Spin-Coating aufgebrachten 60nm-Einzelschicht aus NPB zwischen ITO und Aluminium wieder mit Dotierungen von 5 und 10% Re₂O₇.

Im Vergleich zu den Figuren 5 und 6 aus Beispiel 1 bzw. 2 zeigt sich, dass weder das Lochtransportermatrixmaterial noch die Herstellungsmethode (ob aus Lösung prozessiert oder nicht), den Dotierungsmechanismus beeinflusst.

Referenzbeispiel 5 (nicht gemäß der Erfindung) : Analog zu Beispiel 2, Lochtransportmatrixmaterial ist Poly(3-hexylthiophen (P3HT).

Referenzbeispiel 6 (nicht gemäß der Erfindung) : Analog zu Beispiel 2, Lochtransportmatrixmaterial ist Poly(3,4-ethylenedioxythiophen (PEDOT).

### Beispiel 7:

Analog zu Beispiel 2, Lochtransportmatrixmaterial ist Polyanilin (PANI).

### Beispiel 8:

Eine der Lochtransportschichten aus einem der Beispiele 2 bis 6 wird entsprechend Beispiel 2 hergestellt. Die darauffolgenden Schichten werden aus der Dampfphase abgeschieden, wobei Materialien auf der Basis von small molecules eingesetzt werden. Die emittierenden Schicht(en), Elektroneninjektionsschicht(en) und die Kathode werden in der bekannten Reihenfolge und Technik aufgebracht.

### Beispiel 9:

Eine der Lochtransportschichten aus einem der Beispiele 2 bis 6 wird entsprechend Beispiel 2 hergestellt. Anstelle des Spin-Coatings werden Druckmethoden zur Herstellung der aus Lösung prozessierten Lochtransportschicht und der darauffolgenden Schichten eingesetzt. Als Druckmethoden wurden Rakeln, Siebdruck, Tiefdruck, Tintenstrahl, Flexodruck oder Offsetdruck eingesetzt.

### Beispiel 10:

Analog zu Beispiel 9, wobei wie in Beispiel 8 die darauffolgenden Schichten aus der Dampfphase abgeschieden werden, wobei Materialien auf der Basis von small molecules verwendet werden. Die emittierenden Schicht(en), Elektroneninjektionsschicht(en) und die Kathode werden in der bekannten Reihenfolge und Technik aufgebracht.

### Beispiel 11:

Die OLED/PLED ist als Top-Emitting OLED aufgebaut, wobei der Schichtstapel auf der Kathode aufbaut.

### Beispiel 12:

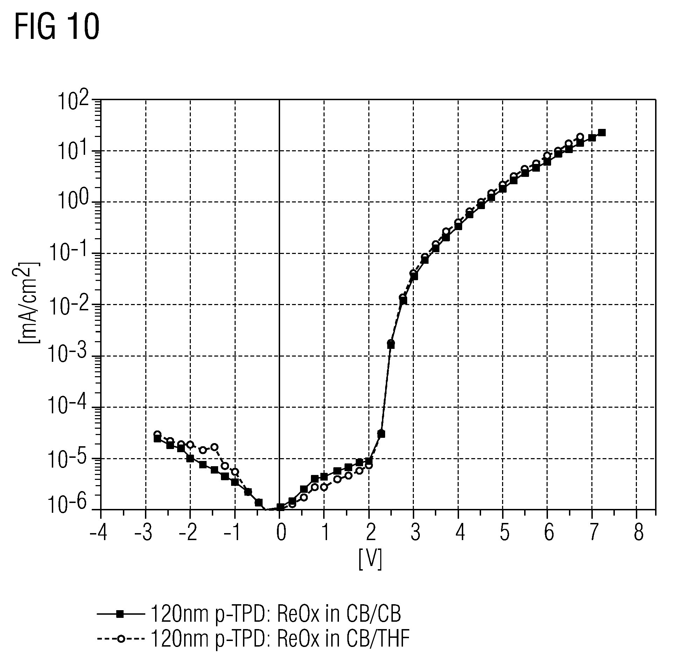

Figur 10 zeigt eine Strom-Spannungskurve einer weißen Leuchtdiode, die mit einer 120nm dicken, über Spin-Coating aufgebrachten und mit 7,5% Re₂O₇ dotierten p-TPD-basierten Lochtransportschicht ausgestattet ist. Auf dieser p-TPD:ReOx (7.5%)-Schicht liegt ein Schichtstapel aus aufgedampften Small Molecules. Die Small Molecule Schichten umfassen phosphoreszente rote und grüne und fluoreszente blaue Emitterschichten. Die Graphik mit den gefüllten Symbolen zeigt das Verhalten der 120nm-Schicht aus p-TPD und ReOx beide aus einer CB-Lösung ohne weitere Lösungsmittel aufgebracht und die Graphik mit den leeren Symbolen zeigt die gleiche Schicht, die aus einer Lösung der Komponenten in CB und THF hergestellt wurde. Offensichtlich ergibt sich ein Unterschied, in welcher Form die Lösung, ob aus einem Lösungsmittel oder einem Lösungsmittelgemisch, prozessiert wird. Der Unterschied in den Kennlinien wird in der linearen Auftragung der Strom-Spannungs-Kennlinien, wie im Einsatz in Figur 10 gezeigt, verdeutlicht.

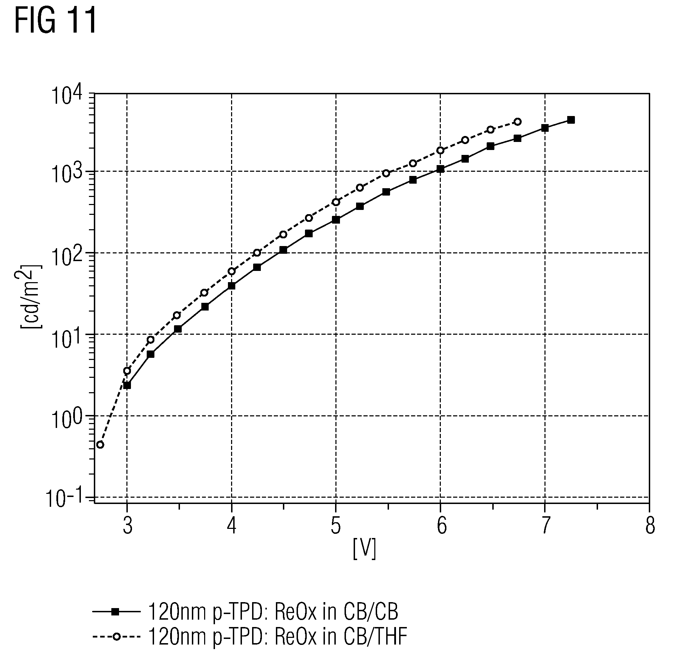

Der höhere Strom im Fall der Dioden mit der Schicht aus PTPD und ReOX hergestellt aus einem Lösemittelgemisch bewirkt eine höhere Lichtausbeute. Figur 11 zeigt die zugehörige Leuchtdichte gegen Spannungs-Messung der weißen emittierenden OLED mit einer 120nm dicken Lochtransportschicht aus p-TPD:ReOx (7,5%). Wieder liegt die Kurve der aus einer CB und THF umfassenden Lösung (leere Symbole) prozessierten Dioden über der Kurve, dieaus einer reinen CB-Lösung prozessiert wurde (gefüllte Symbole).

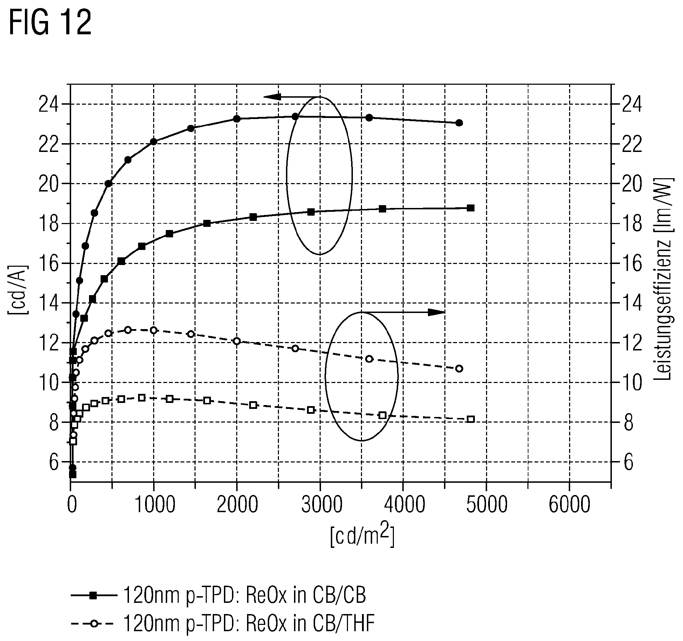

Figur 12 zeigt die Stromeffizienz- (cd/A) und Leistungseffizienzmessung in lm/W gegen Leuchtdichte in cd/m². Die beiden verglichenen Aufbauten sind die aus den Figuren 10 und 11 bereits bekannten, wobei wieder die gefüllten Symbole die aus einer reinen CB-Lösung prozessierten Schichten zeigen und die leeren Symbole die Schichten, bei denen die Rheniumverbindung in THF und das Lochtransportmatrixmaterial in CB gelöst prozessiert wurden. Es ist deutlich erkennbar, dass die aus einem Lösemittelgemisch prozessierten Dioden effizienter sind als die aus einer reinen CB-Lösung hergestellten Dioden.

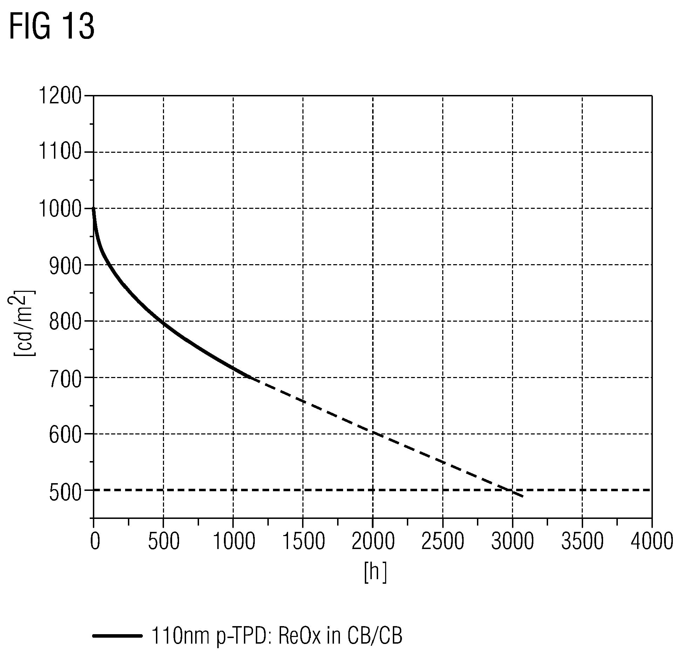

Figur 13 zeigt die Langzeitstabilität der weißen OLED mit einer 120nm dicken, über Spin-Coating aufgebrachten p-TPD-ReOx (7,5%) - Lochtransportschicht. P-TPD und ReOx wurden beide in CB gelöst zur Schicht verarbeitet.

Durch die Erfindung wird erstmals die Verwendung von Rheniumheptoxid als aus Lösung prozessierbares p-Dotierungsmittel in organischen Leuchtdioden vorgeschlagen. Dadurch ergeben sich die folgenden Vorteile:
Eine stabilere p-Dotierung in organischen Leuchtdioden. Eine effizientere Lochtransportschicht führt zu einer höheren Leuchtdichte und einer niedrigeren Betriebsspannung und dadurch zu einer höheren Effizienz der organischen Leuchtdiode. Somit wird die Lebensdauer der organischen Leuchtdiode erhöht.

Es ergibt sich zudem eine Unabhängigkeit von ITO als einzigem Anodenmaterial sowie eine kostengünstige Herstellungsmethode durch Lösung-Prozessierung. Zudem ergibt sich ein Zugang zu Rheniumoxiden, die in niedrigeren Oxidationsstufen vorliegen, was zu einer Änderung und Verbesserung des Aussehens der OLED im off-state führt. Schließlich werden Rhenium-Vorstufen, die für lösungsprozessierbare Formulierungen geeignet sind, geschaffen und letztlich ergibt sich eine geringere Empfindlichkeit gegenüber Feuchtigkeit der Formulierungen aufgrund des Einsatzes von koordinativ gesättigten Rheniumkomponenten.

Erfindungsgemäß wird vorgeschlagen, eine Metallkomponente in Lösung mit dem Lochtransportmatrixmaterial in Lösung zu einer Lochtransportschicht zu verarbeiten.

## Patentansprüche

1. Verfahren zur Herstellung einer Lochtransportschicht mit folgenden Arbeitsschritten:
- Lösen von Rheniumheptoxid in einem Donorenthaltenen Lösungsmittel
- Zugabe einer Lösung eines Lochtransporter-Matrixmaterials,
- nasschemische Aufbringung der Formulierung auf eine untere Schicht
- Sukzessives Entfernen des Donorlösungsmittel durch Thermolyse und Verschieben des Gleichgewichts zwischen Rheniumheptoxid und Donorlösungsmittelmolekül auf die Seite des Charge-Transfer-Komplexes mit dem Lochtransporter-Matrixmaterial nach der Gleichung: 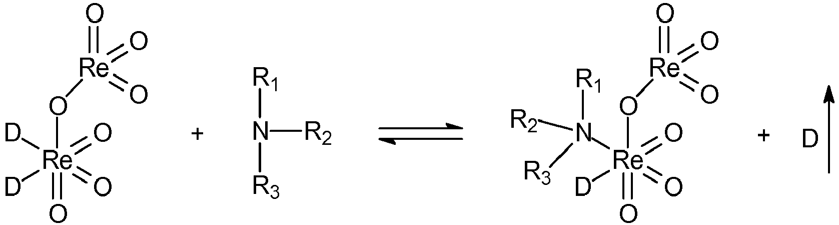 wobei D für die Donorfunktion des Lösungsmittels steht und N (R1, R2 ; R3) für ein LochtransporterMatrixmaterial mit Donorfunktion, wie beispielsweise die Stickstoffdonorfunktion.

2. Verfahren nach Anspruch 1, wobei der Schritt des sukzessiven Entfernens des Donorlösungsmittels bei Temperaturen oberhalb 150°C erfolgt.

3. Verfahren nach einem der Ansprüche 1 oder 2, wobei als Donorhaltige Lösungsmittel Tetrahydrofuran (THF), Toluol, Ethylenglycoldiethylether, Chlorbenzol, Propylenglycolmethyletheracetat, sowie Lösungsmittelgemische eingesetzt werden.

4. Verfahren nach einem der Ansprüche 1 oder 2, wobei der Schritt des Lösens von Rheniumheptoxid in dem Donorlösungsmittel mit einem molaren 2 bis 10-fachen Überschuss an Donorlösungsmittel erfolgt.

5. Verfahren nach einem der vorstehenden Ansprüche, wobei der Arbeitsschritt des nasschemischen Aufbringens über Spin Coating, Sprühen, Aufschleudern oder Drucken, beispielsweise über Doctor-Blading (Rakeln), Gravur-printing (Tiefdruck), Tintenstrahl, Flexodruck oder Offset-Drucken durchgeführt wird.

6. Verfahren nach einem der vorstehenden Ansprüche, wobei als Lochtransporter-Matrixmaterial, Polyvinylcarbazol (PVK), Poly(N,N'-bis,(4-butylphenyl)-N,N'-bis(phenyl)benzidine (PTPD), Polyaniline (PANI) und Poly(3-hexylthiophen(P3HT), sowie beliebige Mischungen dieser Verbindungen eingesetzt wird.

7. Verfahren nach einem der vorstehenden Ansprüche, wobei das Lochtransporter-Matrixmaterial in Form von small molecules eingesetzt wird.

8. Verfahren nach einem der vorstehenden Ansprüche, wobei das Lochtransporter-Matrixmaterial ausgewählt ist aus der Gruppe folgender Verbindungen:
N,N'-Bis(naphthalen-1-yl)-N,N'-bis(phenyl)-9,9-dimethyl-fluoren
N,N'-Bis(3-methylphenyl)-N,N'-bis(phenyl)-9,9-diphenyl-fluoren
N,N'-Bis(naphthalen-1-yl)-N,N'-bis(phenyl)-9,9-diphenyl-fluoren
N,N'-Bis(naphthalen-1-yl)-N,N'-bis(phenyl)-2,2-dimethylbenzidin
N, N'-Bis(3-methylphenyl)-N,N'-bis(phenyl)-9,9-spirobifluoren
2,2',7,7'-Tetrakis(N, N-diphenylamino)-9,9'-spirobifluoren
N, N'-Bis(naphthalen-1-yl)-N,N'-bis(phenyl)-benzidin
N, N'-Bis(naphthalen-2-yl)-N,N'-bis(phenyl)-benzidin
N, N'-Bis(3-methylphenyl)-N,N'-bis(phenyl)-benzidin
N,N'-Bis(3-methylphenyl)-N,N'-bis(phenyl)-9,9-dimethyl-fluoren
N,N'-Bis(naphthalen-1-yl)-N,N'-bis(phenyl)-9,9-spirobifluoren
Di-[4-(N,N-ditolyl-amino)-phenyl]cyclohexan
2,2',7,7'-tetra(N, N-di-tolyl)amino-spiro-bifluoren
9,9-Bis[4-(N,N-bis-biphenyl-4-yl-amino)phenyl]-9H-fluoren
2,2',7,7'-Tetrakis[N-naphthalenyl(phenyl)-amino]-9,9-spirobifluoren
2,7-Bis[N,N-bis(9,9-spiro-bifluorene-2-yl)-amino]-9,9-spirobifluoren
2,2'-Bis[N,N-bis(biphenyl-4-yl)amino]-9,9-spirobifluoren
N, N'-bis(phenanthren-9-yl)-N,N'-bis(phenyl)-benzidin
N, N,N',N'-tetra-naphthalen-2-yl-benzidin
2,2'-Bis(N,N-di-phenyl-amino)-9,9-spirobifluoren
9,9-Bis[4-(N,N-bis-naphthalen-2-yl-amino)phenyl]-9H-fluoren
9,9-Bis[4-(N,N'-bis-naphthalen-2-yl-N,N'-bis-phenyl-amino)-phenyl]-9H-fluoren
Titanium oxide phthalocyanin
Copper phthalocyanin
2,3,5,6-Tetrafluoro-7,7,8,8,-tetracyano-quinodimethan 4, 4', 4" -Tris(N-3-methylphenyl-N-phenyl-amino)triphenylamin
4, 4', 4" -Tris(N-(2-naphthyl)-N-phenyl-amino)triphenylamin
4, 4',4" -Tris(N-(1-naphthyl)-N-phenyl-amino)triphenylamin
4,4',4" -Tris(N,N-diphenyl-amino)triphenylamin Pyrazino[2,3-f][1,10]phenanthroline-2,3-dicarbonitril
N, N,N' ,N' -Tetrakis(4-methoxyphenyl)benzidin 2,7-Bis[N,N-bis(4-methoxy-phenyl)amino]-9,9-spirobifluoren
2,2'-Bis[N,N-bis(4-methoxy-phenyl)amino]-9,9-spirobifluoren
N, N'-di(naphthalen-2-yl)-N,N'-diphenylbenzene-1,4-diamin
N,N'-di-phenyl-N,N'-di-[4-(N,N-di-tolyl-amino)phenyl]benzidin
N,N'-di-phenyl-N,N'-di-[4-(N,N-di-phenyl-amino) phenyl] benzidin, wobei alle vorgenannten Verbindungen allein oder in Kombination vorliegen.

9. Verfahren nach einem der vorstehenden Ansprüche, wobei als Lochtransporter-Matrixmaterial eine Mischung aus PTPD und NPB eingesetzt wird.

10. Organisches elektronisches Bauteil mit einer Lochtransportschicht nach einem der vorstehenden Ansprüche 1 bis 9.

## Claims

1. Method for producing a hole transport layer with the following work steps:
- dissolving of rhenium heptoxide in a donor-containing solvent,
- addition of a solution of a hole transport matrix material,
- wet-chemical application of the formulation onto a lower layer,
- successive removal of the donor solvent by means of thermolysis and displacement of the equilibrium between rhenium heptoxide and donor solvent molecule onto the side of the charge transfer complex with the hole transport matrix material according to the equation: 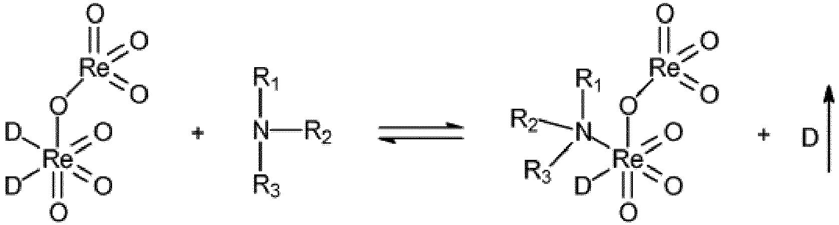 wherein D stands for the donor function of the solvent and N(R₁, R₂; R₃) for a hole transport matrix material with donor function, such as the nitrogen donor function for example.

2. Method according to claim 1, wherein the step of successive removal of the donor solvent takes place at temperatures of greater than 150°C.

3. Method according to one of claims 1 or 2, wherein tetrahydrofuran (THF), toluene, ethylene glycol diethyl ether, chlorobenzene, propylene glycol methyl ether acetate and also solvent mixtures can be used as donor-containing solvents.

4. Method according to one of claims 1 or 2, wherein the step of dissolving rhenium heptoxide in the solvent takes place with a 2- to 10-fold molar excess of donor solvent.

5. Method according to one of the preceding claims, wherein the work step of wet-chemical application is performed by means of spin coating, spraying, spinning on or printing, for example by way of doctor blading, gravure printing, inkjet printing, flexo printing or offset printing.

6. Method according to one of the preceding claims, wherein polyvinylcarbazole (PVK), poly(N,N'-bis,(4-butylphenyl)-N,N'-bis(phenyl)benzidine (PTPD), polyaniline (PANI) and poly(3-hexylthiophene) (P3HT), and also any desired mixtures of these compounds can be used as hole transport matrix material.

7. Method according to one of the preceding claims, wherein the hole transport matrix material is used in the form of small molecules.

8. Method according to one of the preceding claims, wherein the hole transport matrix material is selected from the group of the following compounds:
N,N'-bis(naphthalen-1-yl)-N,N'-bis(phenyl)-9,9-dimethyl-fluorene
N,N'-bis(3-methylphenyl)-N,N'-bis(phenyl)-9,9-diphenyl-fluorene
N,N'-bis(naphthalen-1-yl)-N,N'-bis(phenyl)-9,9-diphenyl-fluorene
N,N'-bis(naphthalen-1-yl)-N,N'-bis(phenyl)-2,2-dimethylbenzidine
N, N'-bis(3-methylphenyl)-N,N'-bis(phenyl)-9,9-spirobifluorene
2,2',7,7'-tetrakis(N, N-diphenylamino)-9,9'-spirobifluorene
N, N'-bis(naphthalen-1-yl)-N,N'-bis(phenyl)-benzidine
N, N'-bis(naphthalen-2-yl)-N,N'-bis(phenyl)-benzidine
N, N'-bis(3-methylphenyl)-N,N'-bis(phenyl)-benzidine
N,N'-bis(3-methylphenyl)-N,N'-bis(phenyl)-9,9-dimethyl-fluorene
N,N'-bis(naphthalen-1-yl)-N,N'-bis(phenyl)-9,9-spirobifluorene
Di-[4-(N,N-ditolyl-amino)-phenyl]cyclohexane
2,2',7,7'-tetra(N, N-di-tolyl)amino-spiro-bifluorene
9,9-bis[4-(N,N-bis-biphenyl-4-yl-amino)phenyl]-9H-fluorene
2,2',7,7'-tetrakis[N-naphthalenyl(phenyl)-amino]-9,9-spirobifluorene
2,7-bis[N,N-bis(9,9-spiro-bifluorene-2-yl)-amino]-9,9-spirobifluorene
2,2'-bis[N,N-bis(biphenyl-4-yl)amino]-9,9-spirobifluorene
N, N'-bis(phenanthren-9-yl)-N,N'-bis(phenyl)-benzidine
N, N,N',N'-tetra-naphthalen-2-yl-benzidine
2,2'-bis(N,N-di-phenyl-amino)-9,9-spirobifluorene
9,9-bis[4-(N,N-bis-naphthalen-2-yl-amino)phenyl]-9H-fluorene
9,9-bis[4-(N, N'-bis-naphthalen-2-yl-N,N'-bis-phenyl-amino)-phenyl]-9H-fluorene
Titanium oxide phthalocyanine
Copper phthalocyanine
2,3,5,6-tetrafluoro-7,7,8,8,-tetracyano-quinodimethane
4,4',4" -tris(N-3-methylphenyl-N-phenyl-amino)triphenylamine
4,4',4" -tris(N-(2-naphthyl)-N-phenyl-amino)triphenylamine
4,4',4" -tris(N-(1-naphthyl)-N-phenyl-amino)triphenylamine
4,4',4" -tris(N,N-diphenyl-amino)triphenylamine
Pyrazino[2,3-f][1,10]phenanthroline-2,3-dicarbonitrile
N, N,N' ,N' -tetrakis(4-methoxyphenyl)benzidine
2,7-bis[N,N-bis(4-methoxy-phenyl)amino]-9,9-spirobifluorene
2,2'-bis[N,N-bis(4-methoxy-phenyl)amino]-9,9-spirobifluorene
N, N'-di(naphthalen-2-yl)-N,N'-diphenylbenzene-1,4-diamine
N,N'-di-phenyl-N,N'-di-[4-(N,N-di-tolyl-amino)phenyl]benzidine
N,N'-di-phenyl-N,N'-di-[4-(N,N-di-phenyl-amino)
phenyl]benzidine, wherein all cited compounds are present alone or in combination

9. Method according to one of the preceding claims, wherein a mixture of PTPD and NPB is used as hole transport matrix material.

10. Organic electronic device with a hole transport layer according to one of the preceding claims 1 to 9.

## Revendications

1. Procédé de fabrication d'une couche de transport de trous comprenant les étapes suivantes consistant à :
- dissoudre de l'heptoxyde de rhénium dans un solvant contenant un donneur
- ajouter une solution d'un matériau de matrice de transport de trous,
- appliquer par voie chimique humide la formulation sur une couche inférieure
- éliminer de manière successive le solvant donneur par thermolyse et déplacement de l'équilibre entre l'heptoxyde de rhénium et la molécule de solvant donneur vers le côté du complexe de transfert de charge comprenant le matériau de matrice de transport de trous conformément à l'équation : 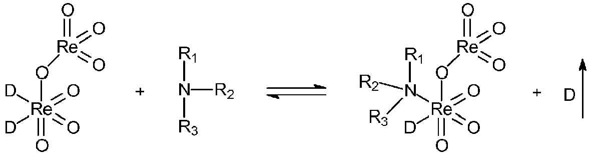 dans lequel D représente la fonction donneur du solvant
et N (R1, R2 ; R3) représente un matériau de matrice de transport de trous comprenant une fonction donneur, comme par exemple la fonction donneur d'azote.

2. Procédé selon la revendication 1, dans lequel l'étape de l'élimination successive du solvant donneur a lieu à des températures supérieures à 150°C.

3. Procédé selon la revendication 1 ou 2, dans lequel du tétrahydrofurane (THF), du toluène, du diéthyléther d'éthylèneglycol, du chlorobenzène, du méthylétheracétate de propylèneglycol, ainsi que des mélanges de solvant, sont utilisés en tant que solvant contenant un donneur.

4. Procédé selon la revendication 1 ou 2, dans lequel l'étape de dissolution de l'heptoxyde de rhénium dans le solvant donneur a lieu avec un excédent molaire de 2 à 10 fois en solvant donneur.

5. Procédé selon l'une quelconque des revendications précédentes, dans lequel l'étape de l'application par voie chimique humide est mise en oeuvre par l'intermédiaire d'une application par centrifugation, d'une projection, d'une centrifugation ou pression, par exemple par l'intermédiaire d'un rouleau preneur (racle), d'une impression par gravure (héliogravure), jet d'encre, flexographie ou impression offset.

6. Procédé selon l'une quelconque des revendications précédentes, dans lequel du polyvinylcarbazol (PVK), de la poly(N,N'-bis,(4-butylphényl)-N,N'-bis(phényl)benzidine (PTPD), de la polyaniline (PANI) et du poly(3-hexylthiophène) (P3HT), ainsi que des mélanges quelconques desdits composés sont utilisés en tant que matériau de matrice de transport de trous.

7. Procédé selon l'une quelconque des revendications précédentes, dans lequel le matériau de matrice de transport de trous est utilisé sous la forme de petites molécules.

8. Procédé selon l'une quelconque des revendications précédentes, dans lequel le matériau de matrice de transport de trous est choisi parmi le groupe constitué des composés suivant :
N,N'-bis(naphthalèn-1-yl)-N,N'-bis(phényl)-9,9-diméthyl-fluorène
N,N'-bis(3-méthylphènyl)-N,N'-bis(phényl)-9,9-diphényl-fluorène
N,N'-bis(naphthalèn-1-yl)-N,N'-bis(phényl)-9,9-diphényl-fluorène
N,N'-bis(naphthalèn-1-yl)-N,N'-bis(phényl)-2,2-diméthylbenzidine
N,N'-bis(3-méthylphènyl)-N,N'-bis(phényl)-9,9-spirobifluorène
2,2',7,7'-tétrakis(N,N-diphénylamino)-9,9'-spirobifluorène
N,N'-bis(naphthalèn-1-yl)-N,N'-bis(phényl)-benzidine
N,N'-bis(naphthalèn-2-yl)-N,N'-bis(phényl)-benzidine
N,N'-bis(3-méthylphènyl)-N,N'-bis(phényl)-benzidine
N,N'-bis(3-méthylphènyl)-N,N'-bis(phényl)-9,9-diméthyl-fluorène
N,N'-bis(naphthalèn-1-yl)-N,N'-bis(phényl)-9,9-spirobifluorène
Di-[4-(N, N-ditolyl-amino)-phényl]cyclohexane
2,2',7,7' -tétra(N,N-di-tolyl)amino-spiro-bifluorène
9,9-bis[4-(N,N-bis-biphényl-4-yl-amino)phényl]-9H-fluorène
2,2',7,7'-tétrakis[N-naphthalènyl(phényl)-amino]-9,9-spirobifluorène
2,7-bis[N,N-bis(9,9-spiro-bifluorène-2-yl)-amino]-9,9-spirobifluorène
2,2'-bis[N,N-bis(biphényl-4-yl)amino]-9,9-spirobifluorène
N,N'-bis(phénanthrèn-9-yl)-N,N'-bis(phényl)-benzidine
N,N,N',N'-tétra-naphthalèn-2-yl-benzidine
2,2'-bis(N,N-di-phényl-amino)-9,9-spirobifluorène
9,9-bis[4-(N,N-bis-naphthalèn-2-yl-amino)phényl]-9H-fluorène
9,9-bis[4-(N,N'-bis-naphthalèn-2-yl-N,N'-bis-phényl-amino)-phényl]-9H-fluorène
oxyde de titane-phthalocyanine
phthalocyanine de cuivre
2,3,5,6-tétrafluoro-7,7,8,8,-tétracyano-quinodiméthane
4,4',4"-tris(N-3-méthylphényl-N-phényl-amino)triphénylamine
4,4',4"-tris(N-(2-naphthyl)-N-phényl-amino)triphénylamine
4,4',4"-tris(N-(1-naphthyl)-N-phényl-amino)triphénylamine
4,4',4"-tris(N,N-diphényl-amino)triphénylamine
pyrazino[2,3-f] [1, 10]phénanthroline-2,3-dicarbonitrile
N,N,N',N'-tétrakis(4-méhoxyphényl)benzidine
2,7-bis[N,N-bis(4-méthoxy-phényl)amino]-9,9-spirobifluorène
2,2'-bis[N,N-bis(4-méthoxy-phényl)amino]-9,9-pirobifluorène
N,N'-di(naphthalèn-2-yl)-N,N'-diphénylbenzène-1,4-diamine
N,N'-di-phényl-N,N'-di-[4-(N,N-di-polylamino)phényl] benzidine
N,N'-di-phényl-N,N'-di-[4-(N,N-di-phényl-amino)phényl] benzidine,
dans lequel tous les composés cités ci-dessus sont présents seuls ou en combinaison.

9. Procédé selon l'une quelconque des revendications précédentes, dans lequel un mélange constitué de PTPD et NPB est utilisé en tant que matériau de matrice de transport de trous.

10. Élément électronique organique avec une couche de transport de trous selon l'une quelconque des revendications 1 à 9 précédentes.
